(19) **Europäisches Patentamt**
**European Patent Office**
**Office européen des brevets**

(11) **EP 4 749 332 A1**

(12) # EUROPEAN PATENT APPLICATION

(43) Date of publication:
**27.05.2026 Bulletin 2026/22**

(51) International Patent Classification (IPC):
***G01T 1/24*** *(2006.01)*

(21) Application number: 25215031.3

(22) Date of filing: **11.11.2025**

(52) Cooperative Patent Classification (CPC):
**G01T 1/243**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **20.11.2024 US 202463722901 P**

(71) Applicant: **Carl Zeiss X-Ray Microscopy, Inc. Dublin, California 94568 (US)**

(72) Inventors:
- **Krenkel, Martin**
  **73447 Oberkochen (DE)**
- **Xu, Xiaochao**
  **Dublin, 94568 (US)**

(74) Representative: **Gulde & Partner**
**Patent- und Rechtsanwaltskanzlei mbB**
**Berliner Freiheit 2**
**10785 Berlin (DE)**

(54) **SEMICONDUCTOR X-RAY DETECTOR WITH LIGHT EMITTING LAYER AND FIBER OPTIC PLATE**

(57) An X-ray detector comprising a semiconductor detector layer coupled with a light-emitting diode, LED, layer on the optical side is provided. The detector features an X-ray-side electrode layer deposited on one side of the semiconductor detector layer and an optical-side electrode layer, such as transparent Indium Tin Oxide, ITO, on the opposite side. The semiconductor detector layer is composed of a high atomic number (Z) material with high density and electrical resistivity to effectively absorb X-ray radiation while minimizing dark current. A fiber optic plate is used to guide the light generated in the LED layer to an optical detector.

EP 4 749 332 A1

## Description

TECHNOLOGICAL BACKGROUND

X-ray microscopy provides high spatial resolution two- and three-dimensional imaging of samples. Implicit in this technology is the need for high X-ray detection efficiency.

Some current X-ray microscopes utilize optical coupling of a thin scintillator X-ray detector to a charge-coupled device (CCD) or complementary metal-oxide-semiconductor (CMOS) camera via an optical microscope. This setup enables high-resolution imaging by first converting the X-ray to light and then detecting the light with conventional cameras.

The optical coupling in scintillator-optical microscope-camera detection systems is not perfect, however. The light collection efficiency is limited because of the finite objective numerical aperture (NA) and light loss in the optical microscope. This results in a reduction in Detective Quantum Efficiency (DQE) for the X-ray detection (the so-called quantum sink) and the direct consequence is a reduction in the imaging throughput.

In the typical collection process, scintillator detection systems lose most of the generated light photons. For example, a 40X (forty times) objective with NA=0.65 collects about 3% of the light generated by the scintillator and a lower NA objective collects even less. As a rough estimate, a system with a 0.65-NA objective and a high-efficiency optical and camera system can collect about 40 photoelectrons from an X-ray photon of 30 keV and often these photoelectrons are collected in several neighboring pixels. While numerical aperture could be increased to increase collection efficiency, this comes at the expense of depth of field, which translates to a lesser scintillator thickness and thus reduced X-ray absorption efficiency.

An alternative method employs a fiber optic plate to couple the scintillator directly to the optical detector. Fiber optic plates consist of numerous fine glass fibers (i.e., optical fibers), each functioning as an individual optical waveguide. These fibers facilitate the direct transfer of light from the scintillator's emission plane to the detection plane of the CMOS, for example, in an optical detector chip, effectively transmitting the generated image with high spatial fidelity.

The fiber optic coupling aims to enhance light collection efficiency by reducing the optical losses typically associated with lens-based systems. Each fiber in the plate maintains the spatial resolution by channeling light from a specific point in the scintillator to a corresponding point on the CMOS detector. This direct coupling minimizes the spreading of light and preserves the integrity of the image, which is crucial for high-resolution X-ray microscopy.

Another option for detecting X-rays or high-energy particle beams utilizes semiconductor direct-conversion detection materials. Materials, such as silicon (Si), gallium arsenide (GaAs), cadmium telluride (CdTe), perovskite-structure semiconductors, or other active materials, are used instead of a scintillator. The absorption of an X-ray photon creates an electron-hole pair cloud, and the free charge carriers are then directed to a pixelated electronic detector via the application of a bias voltage. Multiple electron-hole pair clouds can be integrated and read out, or individual charge cloud pulses can be detected and counted. Silicon-based direct-conversion detectors are only useful for low X-ray energies (e.g. <20 keV) because of the low stopping power of silicon. For harder X-ray radiation, the photon-counting detectors with high-atomic number semiconductor, such CdTe and GaAs are used, which are comparatively expensive.

For example, in US 2021/0311211 A1 and US 2023/0165541 A1, the free charge carriers are directed to a spatial light modulator, such as a liquid crystal (LC) light valve. The electrical charge of the carriers modulates the light valve, which is then illuminated by an external light source of an optical microscope. This configuration can mitigate the loss of light in the optical system over the current scintillator-optical microscope-camera detection systems.

More recently, WO 2023/133491 A1 described a detector that combines a light emitting diode (LED) emission layer in a direct-converting detector in X-ray microscopes. The semiconductor material is coated so that the electron-hole pairs create visible light in the LED layer, which is then observed with the classical optical path of an X-ray microscope. One major benefit is that a thick active material can be used and it is still possible, to achieve high resolution since light generation only occurs in the LED layer. Resolution and sensitivity are therefore no longer coupled. However, in an X-ray microscope, the LEDs are typically observed through microscope objectives, so only small detection areas are common.

The present disclosure aims to overcome or at least reduce the above-mentioned problems and to provide an X-ray detector that allows for improved X-ray detection.

## GENERAL DESCRIPTION

The invention is defined by the appended claims. The description that follows is subjected to this limitation. Any disclosure lying outside the scope of the claims is only intended for illustrative as well as comparative purposes.

The present disclosure concerns X-ray LED detectors, such as in large-area X-ray detectors. The X-ray LED detector may be coupled to a fiber optic plate, FOP, which then may be further connected to a classical detector for visible light such as a CMOS or CCD optical sensor.

According to one aspect of the disclosure, an X-ray detector including a semiconductor detector layer configured to absorb X-ray radiation and to generate charge carriers in response thereto is provided. The semiconductor detector layer may have an X-ray side and an optical side, an X-ray-side electrode layer disposed on the X-ray side of the semiconductor detector layer, a light-emitting diode (LED) layer disposed on the optical side of the semiconductor detector layer. The LED layer may be configured to receive charge carriers from the semiconductor detector layer and to emit light. An optical-side electrode layer may be disposed on the LED layer opposite the semiconductor detector layer. The optical-side electrode layer may include a transparent conductive material. A fiber-optic faceplate (FOP) may be optically coupled to the optical-side electrode layer. The FOP may be configured to guide emitted light while preserving spatial resolution. In other words; the FOR may be configured to guide emitted light and to preserve spatial resolution. A spatially resolved sensor may be positioned to receive light guided by the FOP and to generate an image corresponding to the X-ray radiation distribution. In other words; the X-ray detector may include the semiconductor detector layer and the X-ray-side electrode layer and the LED layer and the optical-side electrode layer and the FOP and the spatially resolved sensor.

In an embodiment, the semiconductor detector layer may include a high atomic number (Z) semiconductor material selected from the group consisting of silicon (Si), amorphous selenium (a-Se), gallium arsenide (GaAs), cadmium zinc telluride (CdZnTe), cadmium telluride (CdTe), and perovskite semiconductor crystals. The semiconductor detector layer may have a thickness ranging from about 2 micrometers to about 10 millimeters, inclusive.

In an embodiment, the spatially resolved sensor may include a two-dimensional pixelated CMOS or CCD chip.

In an embodiment, an immersion oil layer may be positioned between the FOP and the optical-side electrode layer. This may have an advantageous technical effect of enhancing optical coupling through adhesion and refractive index matching.

In some embodiments, the FOP may have fiber diameters significantly smaller than the pixel size of the spatially resolved sensor. This may result in an advantageous technical effect of maintaining high imaging resolution.

In an embodiment, a tapered FOP can also be configured to adjust the effective pixel size by magnifying or demagnifying the image. The image may be magnified or demagnified in a range between 0.25 times and 4 times, inclusive.

Preferably, the FOP may be made of lead glass with a thickness sufficient to protect the spatially resolved sensor from X-ray radiation. Otherwise put; the thickness of the lead glass may be such that the intensity and/or irradiance of X-rays arriving at the spatially resolved sensor may be substantially zero.

According to another aspect, multiple modules of the X-ray detector may be tiled together to form a larger active area, each module having its own bias voltage supply and LED layer. In other words; the detector may be multi-modular and tiling of the multiple modules may form the X-ray detector according to an embodiment. Otherwise put; the X-ray detector may be a "module" and a plurality of such modules may be tiled together to achieve the functionality of the X-ray detector as claimed but over a larger active area. In an embodiment, the X-ray detector may be tiled from multiple modules such that each module has its own bias voltage supply and LED layer. In another embodiment, the bias voltage may be shared (e.g., in a parallel connection) between at least two of the multiple modules. In another embodiment, the X-ray detector may be tiled from multiple modules such that each module has its own controller. In yet another embodiment, the multiple modules may have separate (individual) controllers. This multi-modular aspect may have an advantageous technical effect in operational redundancy and/or easier repair.

According to another aspect of the disclosure, a method of detecting X-ray radiation including the steps: absorbing X-ray photons in a semiconductor detector layer to generate charge carriers, applying an electric field across the semiconductor detector layer using an X-ray-side electrode layer and an optical-side electrode layer, transporting at least one type of charge carrier to a light-emitting diode (LED) layer disposed on the optical side of the semiconductor detector layer, injecting the charge carriers into the LED layer to cause radiative recombination and emit light, guiding the emitted light through a fiber-optic faceplate (FOP) to a spatially resolved sensor, and detecting the guided light with the spatially resolved sensor to generate an image corresponding to the X-ray radiation distribution.

The above and other features of the disclosure including various novel details of construction and combinations of parts, and other advantages, will now be more particularly described with reference to the accompanying drawings and pointed out in the claims. It will be understood that the particular method and device are shown by way of illustration and not as a limitation of the disclosure. The principles and features of this disclosure may be employed in various and numerous embodiments.

## BRIEF DESCRIPTION OF THE DRAWINGS

Features will become apparent to those of ordinary skill in the art by describing in detail exemplary embodiments with reference to the attached drawings in which:

Fig. 1A and 1B are side views showing semiconductor light emitting diode (LED) X-ray detectors with fiber optic plates couplings, according to an embodiment.

Fig. 2 is a side schematic perspective view showing the layers of an example GaAs detector/LED/FOP device, according to an embodiment.

Fig. 3 is a schematic diagram of an X-ray microscope

## DETAILED DESCRIPTION OF THE DRAWINGS

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the embodiments and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Also, all conjunctions used are to be understood in the most inclusive sense possible. Thus, the word "or" should be understood as having the definition of a logical "or" rather than that of a logical "exclusive or" unless the context clearly necessitates otherwise. Further, the singular forms and the articles "a", "an" and "the" are intended to include the plural forms as well, unless expressly stated otherwise. It will be further understood that the terms: includes, comprises, including and/or comprising, when used in this specification, specify the presence of stated features, integers, steps, operations, elements, and/or components, but do not preclude the presence or addition of one or more other features, integers, steps, operations, elements, components, and/or groups thereof. Further, it will be understood that when an element, including component or subsystem, is referred to and/or shown as being connected or coupled to another element, it can be directly connected or coupled to the other element or intervening elements may be present.

It will be understood that although terms such as "first" and "second" are used herein to describe various elements, these elements should not be limited by these terms. These terms are only used to distinguish one element from another element. Thus, an element discussed below could be termed a second element, and similarly, a second element may be termed a first element without departing from the teachings of the present invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

The electronic or electric devices and/or any other relevant devices or components according to embodiments of the present disclosure described herein may be implemented utilizing any suitable hardware, firmware (for example an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, for example on a PCB or another kind of circuit carrier. The conducting elements may include metallization, for example surface metallizations and/or pins, and/or may include conductive polymers or ceramics. Further electrical energy might be transmitted via wireless connections, for example using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random-access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the present disclosure.

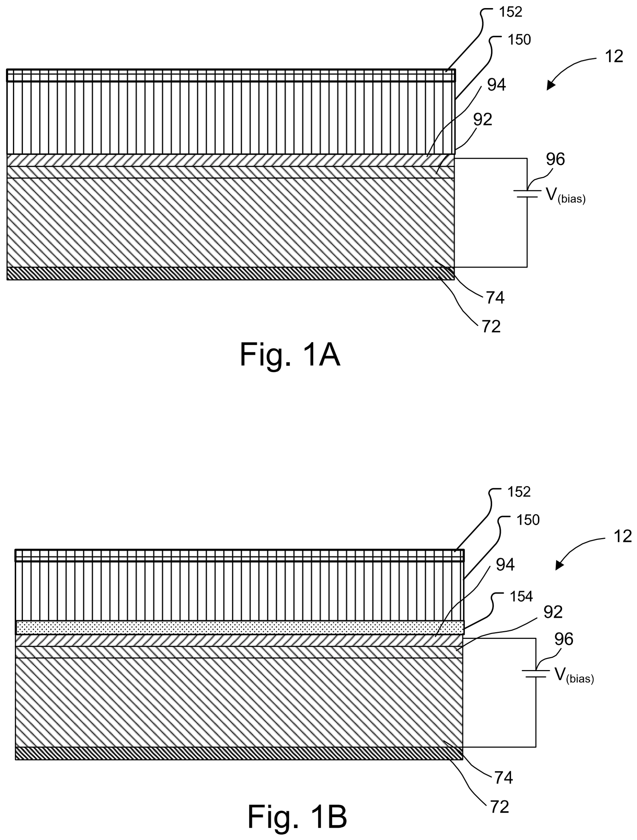

Fig. 1A shows the basic arrangement of semiconductor light emitting diode (LED) X-ray detector 12, according to an embodiment.

The detector 12 comprises LED layer 92 disposed on one side of a semiconductor detector layer 74. An X-ray-side electrode layer 72 is deposited (disposed) on an X-ray side of the semiconductor detector layer 74, i.e., the side from which X-ray arrive at the detector. On an optical-side of the semiconductor detector layer 74 is the LED layer 92 followed by an optical-side electrode layer 94 such as a transparent Indium Tin Oxide (ITO) layer. As seen from Fig. 1A, the optical-side is directly opposite the X-ray side relative to the LED layer 92. Otherwise put; if the optical-side is on a top side of the LED layer 92, then the X-ray side is on a bottom side of the LED layer 92, and *vice versa*. In other words; the optical-side is on the opposite (other) side of the LED layer 92 from the X-ray side.

The semiconductor detector layer 74 is preferably a semiconductor having a relatively high effective atomic number Z and density to effectively stop and absorb the X-ray radiation. The electrical resistivity is preferably high with a value of around or larger than $10^6$ $\Omega$ cm. This has an advantageous technical effect of reducing the dark current. In addition, at least one type of the excited charge carriers (electrons or holes) can be transported through the thickness of the semiconductor layer 74 before it recombines in the absorption layer, i.e. the excited charge carrier that is used for injection into the LED layer 92 preferably has a relatively high mobility-lifetime product $\mu\tau$ (i.e., the result of multiplication of the mobility and the lifetime). This is one property of a semiconductor material, in which $\mu$ is the mobility of the (charge carriers in the) material; and $\tau$ is lifetime of the carriers. Larger $\mu\tau$ is preferred for better detector performance because the charge carriers can move more efficiently through the material (due to a high $\mu$) and the carriers have a longer time to contribute to the detection process before recombining (due to a longer $\tau$). Other requirements are similar to those required with other semiconductor X-ray detectors, such as low polarization and stability over time and other conditions.

The semiconductor layer 74 preferably has a thickness in the range of a few micrometers (such as between 2 and 5 micrometers, inclusive) to 10 mm, inclusive. In one embodiment the semiconductor layer 74 is between approximately 0.5 and 2 mm. That said, a thicker layer is preferred for higher energy X-rays. In different embodiments, this layer is silicon, amorphous selenium (a-Se), GaAs, CdZnTe, CdTe, or crystalline and amorphous perovskite semiconductor crystal materials (with the general formula ABX3, where A and B are positively charged ions (i.e. cations), preferably of very different sizes, and X is a negatively charged ion (i.e. anion).

Referring further to the embodiment of Fig. 1A, a fiber-optic faceplate (FOP) 150 guides the light generated by the LED layer 92 to create a large-area X-ray detector. Advantageously, with the X-ray LED, an FOP coupled X-ray detector can potentially improve one or both quantum efficiency and imaging resolution (with the fiber diameter unchanged).

In an embodiment, a spatially resolved sensor 152 detects the light from the fiber-optic faceplate 150. The sensor 152 is preferably a two-dimensional pixelated CMOS or a CCD chip. In particular, sensors that are preconnected to an FOP 150 are preferably used, and the X-ray LED 92 is simply placed on the sensor by pressing it against the FOP 150 via a holding device such as a clamp to enable the coupling of the light generated in the LED layer 92 into the individual waveguides of the FOP 150.

To image the X-ray radiation distribution generated in the LED layer 92 with sufficient resolution, a FOP 150 is preferably chosen in which fiber diameter is significantly smaller than the pixel size of the sensor 152. For example, there are FOPs 150 with fiber diameters in the range of 3 to 6 $\mu$m, inclusive, which could be used for pixel sizes of, for example, 25 $\mu$m or larger for the sensor 152. Of course, significantly larger sensor pixel sizes in the range of, for example, 50, 100, or 200 $\mu$m or larger are also useable with these small fiber sizes.

In an embodiment, the working mechanism is as follows. A charge cloud (e.g., a cloud of electron-hole pairs) is created within the thick semiconductor layer 74 by absorption of the X-ray photons or particles. The electrons and holes travel in opposite directions due to the applied electric field though the X-ray-side electrode layer 72 and the optical-side electrode layer 94 by a bias voltage source 96. The voltage provided by the voltage source 96 is usually high, such as greater than 10 to 20 Volts (V). Preferably, for a semiconductor layer of 2 mm thickness, the voltage is greater than 100 V such as 200 to 300 V or more. This has an advantageous technical effect of ensuring efficient and rapid charge separation in the device.

One of the charge carrier types is injected into a thin emission zone of the LED layer 92 based on the polarity of the voltage source 96. The LED layer 92 structure is tailored for effective radiative recombination, e.g., Li N, Han K, Spratt W, Bedell S, Ott J, Hopstaken M, et al., Ultra-low-power sub-photon-voltage high-efficiency light-emitting diodes, Nature Photonics, 2019;13(9):588-592. The radiative recombination results in the emission of a photon in the optical (e.g., visible) wavelengths such as a visible light photon, which propagates through the optical-side electrode layer 94 and can then be guided to the optical detector 152 by the FOP 150.

An important requirement for the LED layer 92 is that it operates efficiently over a wide range (concentration) of charge carriers that are injected into the layer. The amount of charge carriers injected depends on the amount of absorbed X-ray photons and thus varies throughout operation. Special layer stacks and growth conditions are preferably considered in order to ensure efficient operation at low charge carrier injection densities. See Li, et al., cited above.

Advantages exist when an organic light emitting diode (OLED) layer is used for the LED layer 92. OLEDs exhibit high efficiencies at low charge carrier injection densities while an efficiency roll-off is usually observed at high charge injection densities. In other words; OLEDs exhibit high efficiencies at low charge carrier injection densities and an efficiency roll-off is usually observed at high charge injection densities. Another advantage of using an OLED is that the layers can be deposited by thermal evaporation on different absorber substrates as no lattice matching has to be taken into account as would be the case for epitaxial techniques which must usually be applied for inorganic semiconductors.

In one embodiment, the detector 12 uses a GaAs-based semiconductor detector absorber layer 74. For the LED layer 92, its related alloys, AlGaAs and InGaAs are preferably used to form a heterostructure. One advantage of GaAs is that it has one of the largest radiative recombination rates among commonly available semiconductor materials. In addition, because of its wide availability, the technologies for making such LEDs are mature and easily available.

The LED-based detector preferably covers a wide range of X-ray flux (or otherwise put; irradiance) levels. When the flux level is low, or for single photon detection, the X-ray-generated current in the detector is rather small. A typical LED has a rather low light efficiency when the driving current is low because non-radiative recombination overtakes radiative recombination at low charge injection rate.

In one example, the LED layer 92 is designed for high efficiency at ultra-low current to overcome the shortcomings of regular LEDs that are usually designed to work at higher injection currents. A single quantum well (QW) is used with a specially designed well and cladding, in one embodiment. The improvements are achieved via two mechanisms: (1) a high-quality InGaAs/InGaP or GaAs/InGaP interface reduces the interface recombination velocity (IRV) and (2) a large valence band offset $Q_v = \frac{\Delta E_v}{(\Delta E_v + \Delta E_c)}$ to make the hole density $p$ much larger than the electron density n within the QW (or a large conduction band offset $Q_c = \frac{\Delta E_c}{(\Delta E_v + \Delta E_c)}$ to make the electron density n much larger than the hole density $p$ within the QW). See Li, et al., cited above.

In another example, the LED layer 92 has a InGaP/GaAs/InGaP double heterojunction, which have been demonstrated for high quantum efficiency. See Li, et al., cited above. In one specific example, the InGaP band gap is 1.90 eV, and the InGaP/GaAs conduction band offset is 0.10 eV and the valence band offset 0.38 eV.

The spatial distribution of light generated in LED layer 92 is then maintained by the FOP 150 as it is transferred to the individual pixels of the sensor 152.

Fig. 1B shows an alternative coupling option, according to an embodiment. The immersion oil (or other immersion medium) layer 154 is used between the FOP 150 and the X-ray LED and specifically the transparent electrode 94 so that it adheres to the FOP 150 by adhesion. The layer 154 also provides refractive index-matching (e.g., refractive index of the layer 154 is within $\pm 0.15$ of the FOP entrance face) The thickness of the layer 154 is preferably 1-50 $\mu$m. Especially when using pixel sizes that are significantly larger (e.g. 100 $\mu$m sensor pixel size) than the typical size of the visible light generation spot in the LED layer (e.g. < 20 $\mu$m), there is no disadvantage in that the generated light must propagate larger distances in the electrode layer or immersion oil. The blur introduced by the additional immersion oil layer will still be smaller than the sensor pixel size and the FOP transmission will not introduce any significant additional blur.

One way to influence the effective area of the X-ray detector is to use tapered FOPs, which can effectively reduce or enlarge the image generated by the X-ray LED, to control the effective pixel size of the X-ray detector in a desired direction. For example, there are tapered FOPs that have a (de)magnification of a factor of 4, which could be used to couple a large area X-ray LED to a smaller sensor. Alternatively, the tapered FOP could be mounted in the other direction, to enlarge the resolution, e.g. to achieve 25 $\mu$m effective pixel size with real 100 $\mu$m pixels. In this way, the tapered FOP can be used to deal with any mismatch between X-ray and optical detector sizes.

One disadvantage of active semiconductor materials is that they typically cannot be produced with large dimensions. Typical dimensions for a single-crystal perovskite are of the order of about 50 millimeters (mm). To achieve active area sizes of several hundred millimeters, multiple smaller elements can be tiled together to fill the larger areas of the optical sensors or the FOP. The several modules can have their own connectors to supply the bias voltage and their own LED layer. Alternatively, single electrodes in front and back of the active material and a single LED layer are preferably be used. The tiling typically introduces small gaps between the modules, for example due to non-ideal edge properties. The influence of these edge effects in the X-ray image will be noticeable as changed sensitivity of the respective pixels at the transitions, which can be compensated by a flat-field correction, i.e. by recording one or more images without any object and compensating for static deviations in the images. When multiple images for different exposure conditions (e.g. different read-out time, different attenuation due to prefilters) are used, non-linear behavior of pixels can also be compensated.

One preferred way to build an FOP-based detector with X-ray LED is to use fiber optic plates made of lead glass. By choosing the thickness of the lead glass FOP, the typically radiation-sensitive sensor can be protected against the X-ray radiation. The thicker the FOP, the higher the X-ray energies the detector can withstand.

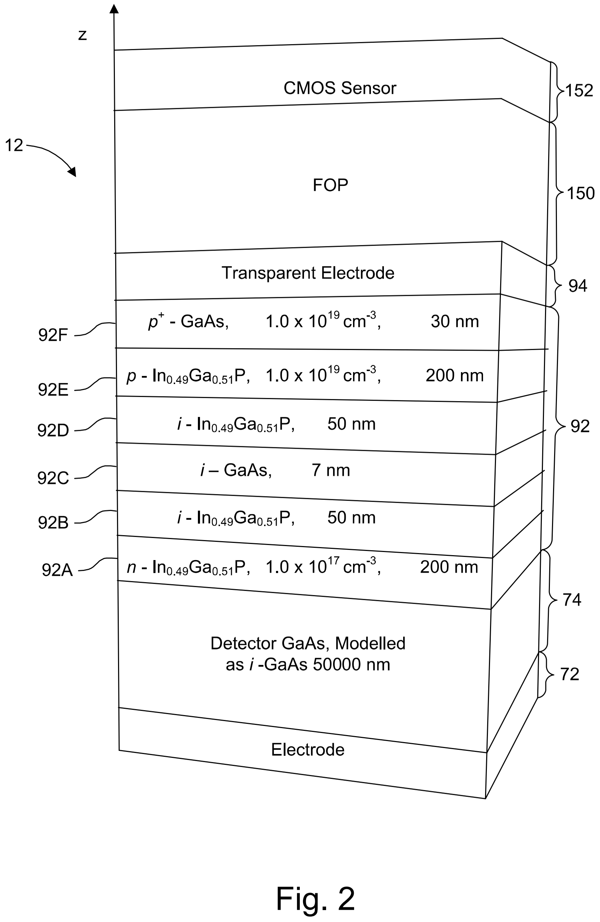

Fig. 2 shows one specific embodiment of the detector 12.

In an embodiment, the semiconductor detector absorber layer 74 is a thick GaAs layer for detecting X-ray radiation. The thick GaAs layer is preferably between 0.1 to 100 microns thick, though it can exceed 100 microns in some embodiments. It is disposed on the X-ray-side electrode layer 72. The LED heterostructure layer 92 includes - from the bottom up - an n-type $In_{0.49}Ga_{0.51}P$ contact layer 92A of 200 nanometers (nm), followed by an $In_{0.49}Ga_{0.51}P$ layer 92B of 50 nm, a GaAs layer 92C layer of 7 nm, and another $In_{0.49}Ga_{0.51}P$ layer 92D of 50 nanometers to form a double heterojunction. A p-type $In_{0.49}Ga_{0.51}As$ hole contact layer 92E of 200 nm thickness and a $p^+$ GaAs hole contact layer 92F of 30 nm thickness are used before the (transparent) optical-side electrode layer 94. In an embodiment, layer 92A has a nominal carrier concentration of $1 \times 10^{17}$ cm$^{-3}$; layer 92E has a nominal carrier concentration of $1 \times 10^{19}$ cm$^{-3}$ and layer 92F has a nominal carrier concentration of $1 \times 10^{19}$ cm$^{-3}$.

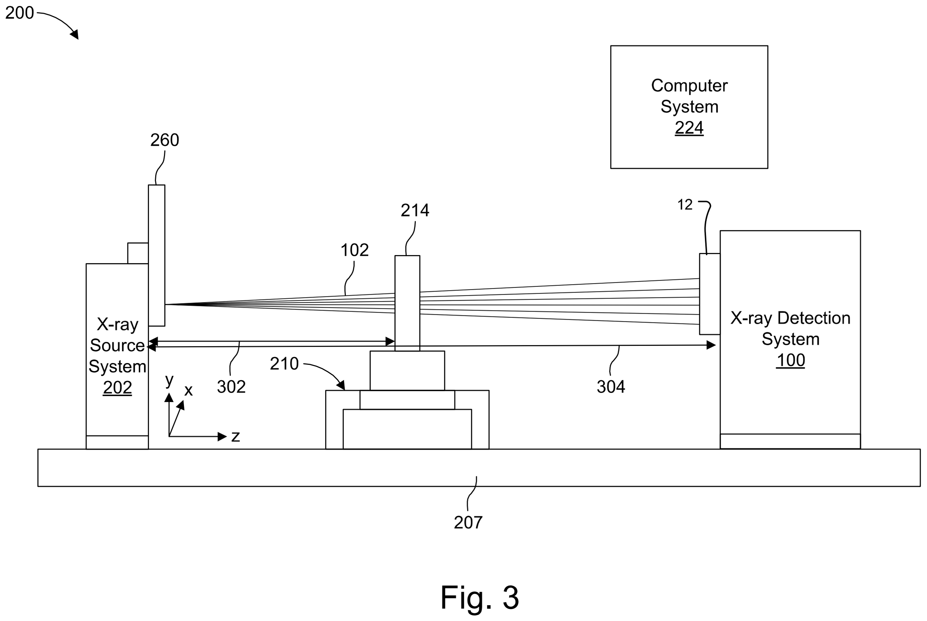

Fig. 3 is a schematic diagram of an X-ray CT microscopy system 200 comprising the X-ray detection system 100 and its semiconductor LED X-ray detector 12, according to an embodiment.

Nevertheless, the present invention is applicable to charged particle analysis systems and non-microscopy systems. In other words, the X-ray detector as claimed may (also) be employed in systems other than X-ray microscopes, e.g., scanning electron microscopes, transmission electron microscopes, helium ion microscopes, etc.

The microscope 200 preferably includes an X-ray imaging system that has an X-ray source system 202 configured for generating a polychromatic X-ray beam 102 that is then filtered, or possibly a monochromatic X-ray beam 102, and an object stage system 210 with an object holder 212 (not pictured) for holding an object 214 and positioning the object 214 to enable scanning of the object 214 in the stationary beam 102. The X-ray detection system 100 detects the beam 102 after it has been modulated by the object 214. Preferably, a base such as a platform or optics table 207 provides a stable foundation for the microscope 200.

In an embodiment, the object stage system 210 is configured to position and rotate the object 214 in the beam 102.

The source system 202 may be any kind of radiation source with a suitable energy or energy-range, such as an open or closed X-ray tube with transmission or reflection targets. Also, other kinds of X-ray sources like synchrotron radiation are possible in other embodiments.

The X-ray beam 102 generated by source 202 is preferably conditioned to suppress unwanted energies or wavelengths of radiation especially when using a laboratory X-ray source. For example, undesired wavelengths present in the beam 102 are eliminated or attenuated, using, for instance, energy filters designed to select a desired X-ray wavelength range (bandwidth) held in a filter wheel 260. Conditioning is also often provided by collimators or condensers and/or an X-ray lens such as a zone plate lens (not pictured).

When the object 214 is exposed to the X-ray beam 102, the X-ray photons transmitted through the object 214 form a modulated X-ray beam that is received by the detection system 100. In an embodiment, the X-ray detector 12 is disposed in/on the X-ray detection system 100 and is electronically and operatively connected to it. In some other examples, a zone plate objective X-ray lens is used to form an image onto X-ray detection system 100.

Typically, a magnified projection image of the object 214 is formed on the detection system 100. The geometrical magnification is preferably equal to the ratio of the source-to-detector distance 304 and the source-to-object distance 302.

The operation of the system 200 and the scanning of the object 214 is controlled by a computer system 224 that preferably includes an image processor subsystem, a controller subsystem. The computer system 224 is configured to set bias voltages 96 of the detector 12 and to read out the optical images detected by the sensor 152 of the detection system 100. The computer system 224, with the possible assistance of its image processor, is configured to accept the set of images from the detection system 100 associated with each rotation angle of the object 214 to build up a scan.

It should be noted that the computer system 224 need not be a unitary device. For example, a single-board computer or a microcontroller might be used as the control system for the microscopy system 200, in an embodiment. In yet another embodiment, a separate computer might be used to process the images generated by the sensor 152 to generate the spatially and spectrally resolved object images or projections of the object 214 and/or to perform tomographic reconstruction of the object 214 based on the various projections. In fact, the sensor images might be stored and then later processed or reprocessed in order to generate the object images and reconstructions. As a result, a special purpose computer such as a graphic processing unit (GPU), application specific integrated circuit (ASIC), field programmable array (FPGA), general purpose computer or some combination of these or other computer systems can be included as part of the computer system 224 to process the images. In addition, these computer systems could also be integrated within the X-ray detection system 100.

While this disclosure has been particularly shown and described with references to preferred embodiments thereof, it will be understood by those skilled in the art that various changes in form and details may be made therein without departing from the scope encompassed by the appended claims.

**List of reference signs**

| 12 | Detector |
|----|----------|
| 72 | X-ray-side electrode layer |
| 74 | Semiconductor detector layer |
| 92 | LED heterostructure layer |
| 92A | n-type In0.49Ga0.51P contact layer |
| 92B | In0.49Ga0.51P layer |
| 92C | GaAs layer |
| 92D | Another In0.49Ga0.51P layer |
| 92E | p-type In0.49Ga0.51As hole contact layer |
| 92F | p+ GaAs hole contact layer |
| 94 | Optical-side electrode layer |
| 96 | Voltage source |
| 100 | X-ray detection system |
| 102 | X-ray beam |
| 119 | USC |
| 150 | Fiber-optic faceplate |
| 152 | Sensor |
| 154 | Immersion medium layer |
| 200 | X-ray CT microscopy system |
| 202 | X-ray source system |
| 207 | Base |
| 210 | Object stage system |
| 212 | Object holder |
| 214 | Object |
| 224 | Computer system |
| 260 | Filter wheel |
| 302 | Source-to-object distance |
| 304 | Source-to-detector distance |

**Claims**

1. An X-ray detector (12) comprising:

   a semiconductor detector layer (74) configured to absorb X-ray radiation and to generate charge carriers in response thereto, the semiconductor detector layer (74) having an X-ray side and an optical side;
   an X-ray-side electrode layer (72) disposed on the X-ray side of the semiconductor detector layer (74);
   a light-emitting diode, LED, layer (92) disposed on the optical side of the semiconductor detector layer (74), the LED layer (92) configured to receive the charge carriers from the semiconductor detector layer (74) and to emit light;
   an optical-side electrode layer (94) disposed on a first side of the LED layer (92) that is opposite to a second side of the LED layer (92) on which the semiconductor detector layer (12) is disposed, the optical-side electrode layer (94) comprising a transparent conductive material;
   a fiber-optic faceplate, FOP, (150) configured to optically couple to the optical-side electrode layer (94), and to guide emitted light and to preserve spatial resolution; and
   a spatially resolved sensor (152) configured to receive the light guided by the FOP (150) and to generate an image corresponding to the X-ray radiation distribution.

2. The X-ray detector (12) of claim 1, wherein the semiconductor detector layer (74) comprises a semiconductor material selected from the group consisting of silicon (Si), amorphous selenium (a-Se), gallium arsenide (GaAs), cadmium zinc telluride (CdZnTe), cadmium telluride (CdTe), and a perovskite semiconductor crystal.

3. The X-ray detector (12) of claim 1, wherein the semiconductor detector layer (74) has a thickness from 2 micrometers to 10 millimeters, inclusive.

4. The X-ray detector (12) of claim 1, wherein the spatially resolved sensor (152) comprises a two-dimensional pixelated CMOS or CCD chip.

5. The X-ray detector (12) of claim 1, further comprising an immersion oil layer (154) positioned between the FOP (150) and the optical-side electrode layer (94), the immersion oil layer (154) being configured to enhance optical coupling through adhesion and refractive index matching.

6. The X-ray detector (12) of claim 1, wherein the FOP (150) has fiber diameters smaller than a pixel size of the spatially resolved sensor (152) to maintain high imaging resolution.

7. The X-ray detector (12) of claim 1, wherein the FOP (150) is a tapered fiber-optic faceplate configured to adjust the effective pixel size by magnifying or demagnifying the image, such as between $0.25\times$ and $4\times$, inclusive.

8. The X-ray detector (12) of claim 1, wherein the FOP (150) is made of lead glass with a thickness sufficient to protect the spatially resolved sensor (152) from X-ray radiation.

9. An X-ray detector wherein multiple modules of the detector (12) of claim 1 are tiled together to form a larger active area, each of the multiple modules having its own bias voltage (96) supply and LED layer (92).

10. A method of detecting X-ray radiation, comprising the steps:

   absorbing X-ray photons in a semiconductor detector layer (74) to generate charge carriers;
   applying an electric field across the semiconductor detector layer (74) using an X-ray-side electrode layer (72) and an optical-side electrode layer (94);
   transporting at least one type of generated charge carrier to a light-emitting diode, LED, layer (92) disposed on the optical side of the semiconductor detector layer (94);

injecting the transported charge carriers into the LED layer (92) to cause radiative recombination and to emit light;

guiding the emitted light through a fiber-optic faceplate, FOP, (150) to a spatially resolved sensor (152); and

detecting the guided light with the spatially resolved sensor (152) to generate an image corresponding to the X-ray radiation distribution.

11. The method of claim 10, further comprising enhancing optical coupling between the LED layer (92) and the FOP (150) with an immersion oil layer (154) disposed between the FOP (150) and the LED layer (92).

12. The method of claim 10, wherein the semiconductor detector layer (74) comprises a high-Z material with a high electrical resistivity and a high mobility-lifetime product, $\mu\tau$, configured for providing efficient charge carrier transport and a reduced dark current.

13. The method of claim 10, further comprising using a tapered FOP (150) configured to adjust the effective pixel size by magnifying or demagnifying the emitted light image.

14. The method of claim 10, wherein the FOP (150) is made of lead glass configured to protect the spatially resolved sensor (152) from X-ray exposure.

15. The method of claim 10, wherein multiple detector modules are tiled to cover a larger area and to compensate for edge effects through flat-field correction techniques.

Fig. 1A

Fig. 1B

z

12

CMOS Sensor — 152

FOP — 150

Transparent Electrode — 94

92F — $p^+$ - GaAs,     $1.0 \times 10^{19}$ cm$^{-3}$,     30 nm

92E — $p$ - In$_{0.49}$Ga$_{0.51}$P,   $1.0 \times 10^{19}$ cm$^{-3}$,     200 nm

92D — $i$ - In$_{0.49}$Ga$_{0.51}$P,     50 nm

92C — $i$ – GaAs,     7 nm

92B — $i$ - In$_{0.49}$Ga$_{0.51}$P,     50 nm

92A — $n$ - In$_{0.49}$Ga$_{0.51}$P,   $1.0 \times 10^{17}$ cm$^{-3}$,     200 nm

92

Detector GaAs, Modelled as $i$ -GaAs 50000 nm — 74

Electrode — 72

Fig. 2

Fig. 3

| Europäisches Patentamt European Patent Office Office européen des brevets | **EUROPEAN SEARCH REPORT** | **Application Number** EP 25 21 5031 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 483 094 B1 (YAHAV GIORA [IL] ET AL) 19 November 2002 (2002-11-19) | 1-4,10, 12 | INV. G01T1/24 |
| Y | * column 2, lines 32-39; figures 1-3, 4B * * column 6, lines 19-45 * * column 7, lines 2-7 * * column 3, lines 37-45 * * column 8, line 60 - column 9, line 17 * | 5-8,11, 13,14 | |
| Y,D | WO 2023/133491 A1 (CARL ZEISS X RAY MICROSCOPY INC [US]) 13 July 2023 (2023-07-13) * paragraphs [0006] - [0015], [0071] - [0073], [0081]; figures 1,2,14 * | 1-15 | |
| Y | T Schulman: "Si, CdTe and CdZnTe radiation detectors for imaging applications" In: "Si, CdTe and CdZnTe radiation detectors for imaging applications", 1 January 2006 (2006-01-01), XP055036824, * page 13, paragraph 3.3 * | 1-15 | |
| Y | WO 02/16990 A1 (KONINKL PHILIPS ELECTRONICS NV [NL]) 28 February 2002 (2002-02-28) * page 1, lines 1-7, 20-21 * * page 2, lines 13-30 * | 5,11 | TECHNICAL FIELDS SEARCHED (IPC) G01T H10F G21H G02B B22F |
| Y | WO 2020/188253 A1 (UNITIVE DESIGN AND ANALYSIS [GB]) 24 September 2020 (2020-09-24) * page 1, lines 32-36; figures 1,4-7 * * page 2, lines 6-11 * * page 11, line 35 * * page 12, lines 4-7 * | 6-8,13, 14 | |

The present search report has been drawn up for all claims

| Place of search | Date of completion of the search | Examiner |
|---|---|---|
| The Hague | 26 March 2026 | Van Ouytsel, Krist'l |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    

& : member of the same patent family, corresponding document

EPO FORM 1503 03.82 (P04C01)

EP 4 749 332 A1

## ANNEX TO THE EUROPEAN SEARCH REPORT
## ON EUROPEAN PATENT APPLICATION NO.

EP 25 21 5031

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2026

| Patent document cited in search report | | Publication date | Patent family member(s) | | Publication date |
|---|---|---|---|---|---|
| US 6483094 | B1 | 19-11-2002 | AU | 2175897 A | 30-10-1998 |
| | | | EP | 0985234 A1 | 15-03-2000 |
| | | | JP | 2002508885 A | 19-03-2002 |
| | | | US | 6483094 B1 | 19-11-2002 |
| | | | WO | 9845885 A1 | 15-10-1998 |
| WO 2023133491 | A1 | 13-07-2023 | CN | 118511280 A | 16-08-2024 |
| | | | EP | 4445421 A1 | 16-10-2024 |
| | | | US | 2025072152 A1 | 27-02-2025 |
| | | | WO | 2023133491 A1 | 13-07-2023 |
| WO 0216990 | A1 | 28-02-2002 | AT | E281658 T1 | 15-11-2004 |
| | | | DE | 60106944 T2 | 03-11-2005 |
| | | | EP | 1311892 A1 | 21-05-2003 |
| | | | JP | 2004507786 A | 11-03-2004 |
| | | | KR | 20020042873 A | 07-06-2002 |
| | | | US | 2002067897 A1 | 06-06-2002 |
| | | | WO | 0216990 A1 | 28-02-2002 |
| WO 2020188253 | A1 | 24-09-2020 | GB | 2582181 A | 16-09-2020 |
| | | | WO | 2020188253 A1 | 24-09-2020 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20210311211 A1
- US 20230165541 A1

- WO 2023133491 A1

**Non-patent literature cited in the description**

- **LI N ; HAN K ; SPRATT W ; BEDELL S ; OTT J ; HOPSTAKEN M et al.** Ultra-low-power sub-photon-voltage high-efficiency light-emitting diodes. *Nature Photonics*, 2019, vol. 13 (9), 588-592